# EUROPEAN PATENT APPLICATION

(11) **EP 4 668 474 A1**
(43) Date of publication of application: **24.12.2025**
(21) Application number: 24757295.1
(22) Date of filing: 16.02.2024
(51) Int. Cl.: H01Q 1/02, H05K 7/20

(54) **ACTIVE HEAT DISSIPATION APPARATUS**

(30) Priority: 17.02.2023 KR 20230021535; 15.02.2024 KR 20240021435
(71) Applicant: KMW Inc., Hwaseong-si, Gyeonggi-do 18462 (KR)
(72) Inventor: SEO, Jin Kook, Busan 46726 (KR)
(74) Representative: impuls legal PartG mbB
(86) International application number: PCT/KR2024/095253
(87) International publication number: WO 2024/172577

(57) **Abstract**

The present invention relates to an active heat dissipation apparatus comprising: a heat conduction panel body, which is made of a thermally conductive material and comprises a heat conduction panel on one side and a heat conduction panel on the other side that respectively constitute one side and the other side of a thickness portion, forming a refrigerant flow space of a predetermined thickness in which a refrigerant is filled and flows; a plurality of joints arranged on each of the heat conduction panel on one side and the heat conduction panel on the other side to join the heat conduction panels in the refrigerant flow space; and an absorber disposed in the refrigerant flow space to absorb a liquid refrigerant among the refrigerant, wherein the plurality of joints are interconnected by penetrating the absorber in a thickness direction, thereby providing the advantage of significantly improving heat dissipation performance.

## Description

### [Technical Field]

The present disclosure relates to an active heat dissipation apparatus, and more particularly, to an active heat dissipation apparatus capable of improving heat dissipation performance by actively transferring heat generated from a heat-generating device (e.g., an electronic device) through a phase change of a refrigerant, which is more effective than heat transfer based on the thermal conductivity of the heat dissipation apparatus itself.

### [Background Art]

Wireless communication technology, for example, multiple input multiple output (MIMO) technology is a technique that significantly increases data transmission capacity by using multiple antennas, and employs a spatial multiplexing scheme in which a transmitter transmits different data through respective transmission antennas and a receiver distinguishes among transmission data through appropriate signal processing.

Accordingly, as the numbers of transmission and reception antennas increase together, the channel capacity increases, allowing a larger amount of data to be transmitted. For example, when the number of antennas is increased to ten, approximately ten times the channel capacity can be achieved using the same frequency band compared to an existing single-antenna system. In transmission and reception apparatuses to which the MIMO technology is applied, an increase in the number of antennas also increases the number of transmitters and filters.

As the number of transmitters and filters increases, the number of heat-generating elements also increases, which presents a problem. In order to prevent performance degradation of the antenna apparatus, the MIMO technology requires prior research on a heat dissipation structure capable of effectively dissipating heat generated from a plurality of heat-generating elements.

In particular, recently, active research has been conducted on efficiently cooling heat generated from operation of systems in not only antenna apparatuses but also electrically driven electronic devices, in order to optimize performance and prevent accidents such as explosions caused by overheating.

However, heat generated from operation of the systems is typically dissipated by transferring the heat from internal heat-generating elements to the outside through a material with high thermal conductivity, enabling heat exchange with external air. The aforementioned approach, however, faces a limitation in the thermal conductivity of the material of a cooling medium itself.

### [DISCLOSURE]

### [Technical Problem]

The present disclosure has been made in an effort to solve the above-mentioned technical problem, and is directed to providing an active heat dissipation apparatus capable of improving the heat dissipation performance of a heat-generating device (electronic device).

Furthermore, the present disclosure is directed to providing a heat dissipation apparatus with excellent manufacturability.

Technical objects of the present disclosure are not limited to the aforementioned objects, and other objects not described above may be evidently understood from the following description by those skilled in the art.

### [Technical Solution]

An active heat dissipation apparatus according to an embodiment of the present disclosure may include: a thermal conduction panel body made of a thermally conductive material, and forming a refrigerant flow space with a predetermined thickness in which a refrigerant is filled and flows, the thermal conduction panel body including a first thermal conduction panel and a second thermal conduction panel that respectively form a first surface and a second surface of a thickness portion; a plurality of joint portions respectively formed on the first thermal conduction panel and the second thermal conduction panel, and configured to join the first thermal conduction panel and the second thermal conduction panel to each other in the refrigerant flow space; and an absorber disposed in the refrigerant flow space and configured to absorb a liquid-phase portion of the refrigerant. The plurality of joint portions may pass through the absorber in a thickness direction and may be joined to each other.

The active heat dissipation apparatus may further include a plurality of absorber retaining portions provided on at least one of the first second thermal conduction panel and the second thermal conduction panel and configured to retain the absorber in place.

Furthermore, the plurality of absorber retaining portions may be disposed to support an outer side of at least one of a first side surface and a second side surface of the absorber.

Furthermore, the absorber may be spaced apart from and disposed parallel to the first thermal conduction panel and the second thermal conduction panel at an intermediate position in the thickness portion of the refrigerant flow space.

In addition, among the plurality of absorber retaining portions, the absorber retaining portion formed on the first thermal conduction panel supports the first side surface of the absorber facing the first thermal conduction panel, out of the first side surface and the second side surface of the absorber. Among the plurality of absorber retaining portions, the absorber retaining portion formed on the second thermal conduction panel supports the second side surface of the absorber facing the second thermal conduction panel, out of the first side surface and the second side surface of the absorber.

In addition, the plurality of absorber retaining portions may include a first absorber retaining portion protruding from the first thermal conduction panel toward the second thermal conduction panel, and a second absorber retaining portion protruding from the second thermal conduction panel toward the first thermal conduction panel, the first and second absorber retaining portions supporting the absorber at a same point.

Moreover, the plurality of absorber retaining portions may support the absorber without passing through one surface of the absorber.

Furthermore, the absorber may include a first absorption element disposed in close contact with an inner surface of the first thermal conduction panel in the refrigerant flow space, and a second absorption element disposed in close contact with an inner surface of the second thermal conduction panel in the refrigerant flow space.

Furthermore, the plurality of absorber retaining portions may include a first absorber retaining portion protruding from the first thermal conduction panel toward the second thermal conduction panel, and second absorber retaining portion protruding from the second thermal conduction panel toward the first thermal conduction panel. The first absorber retaining portion may pass through the first absorption element and supports the second absorption element. The second absorber retaining portion may pass through the second absorption element and support the first absorption element.

Furthermore, the absorber may include a plurality of joint portion through-holes formed therein such that the plurality of joint portions pass through the absorber and come into surface contact with each other.

In addition, the plurality of joint portions and the plurality of absorber retaining portions may be alternately and repeatedly arranged at intervals to be aligned in a straight line direction on the thermal conduction panel body.

In addition, when at least one end of the thermal conduction panel body, in a state where the first thermal conduction panel and the second thermal conduction panel are joined, forms a press-fitting edge that is disposed adjacent to heat-generating elements, which are heat dissipation targets, the absorber may be disposed such that at least a portion of the absorber is disposed linearly along the press-fitting edge.

Furthermore, when a region of each of the first thermal conduction panel and the second thermal conduction panel excluding the press-fitting edge is defined as a heat dissipation plate portion, a remaining region of the absorber may be bent and linearly extended toward a region, located at a relatively lower side with respect to a direction of gravity, of the heat dissipation plate portion.

Furthermore, the first thermal conduction panel and the second thermal conduction panel may each be provided with at least one chamber partition portion that, after joining the first and second thermal conduction panels, partitions the refrigerant flow space into at least two or more spaces, and during the joining, the chamber partition portions of the first and second thermal conduction panels are joined to each other.

Furthermore, in at least the two or more refrigerant flow spaces partitioned by the chamber partition portion, the absorber may be disposed in a number corresponding to the number of refrigerant flow spaces.

Moreover, the press-fitting edge may be provided with a refrigerant filling port communicating with the refrigerant flow space to allow the refrigerant flow space to be filled with the refrigerant.

In addition, the active heat dissipation apparatus may further include a caulking element that is inserted, after the refrigerant flow space is filled with the refrigerant, into the refrigerant filling port and seals the refrigerant flow space by crimping the refrigerant filling port.

In addition, after the caulking element is inserted into the refrigerant filling port, the refrigerant filling port including the caulking element may be cut to match an outer end of the press-fitting edge.

Furthermore, when an edge opposite to the press-fitting edge is defined as a heat dissipation edge, a rigidity rib configured to increase rigidity may be formed along the heat dissipation edge.

Furthermore, the rigidity rib may include a first rigidity rib groove formed to be recessed from the first thermal conduction panel toward an outer side of the refrigerant flow space, and a second rigid rib groove formed to be recessed from the second thermal conduction panel toward the outer side of the refrigerant flow space.

### [Advantageous Effects]

According to an embodiment of the active heat dissipation apparatus of the present disclosure, overall heat dissipation performance may be significant improved by enabling active heat transfer through a phase change of a refrigerant.

### [Description of Drawings]

FIG. 1 is a perspective view illustrating an example of an active heat dissipation apparatus coupled to an antenna apparatus among electronic devices.
FIG. 2 is an exploded perspective view illustrating a state in which the active heat dissipation apparatus is separated from the configuration of FIG. 1.
FIG. 3 is a perspective view illustrating an active heat dissipation apparatus according to an embodiment of the present disclosure.
FIG. 4 is an exploded perspective view of FIG. 3.
FIG. 5 is a developed view illustrating an unjoined state of FIG. 3.
FIG. 6 is a front view (a) of FIG. 4, cross-sectional views (b) and (c) taken along lines A-A and B-B, and enlarged views of portions thereof.
FIG. 7 is a sectional perspective view taken along line A-A of FIG. 6, and an enlarged view of a portion thereof.
FIG. 8 illustrates perspective views of active heat dissipation apparatuses according to other embodiments 200B, 200C, and 200D of the present disclosure.
FIG. 9 is an exploded perspective view of another embodiment 200B referred to as (a) in FIG. 8.
FIG. 10 is a developed view illustrating an unjoined state of another embodiment 200B referred to as (a) in FIG. 8.
FIG. 11a illustrates a front view (a) of another embodiment 200B referred to as (a) in FIG. 8, a cross-sectional view (b) and a sectional perspective view (c) taken along line C-C, and an enlarged view (d) of a portion thereof.
FIG. 11b illustrates a front view (a) of another embodiment 200B referred to as (a) in FIG. 8, a cross-sectional view (b) and a sectional perspective view (c) taken along line D-D, and an enlarged view (d) of a portion thereof.

### [Description of Reference Numerals]

100:antenna device 110:heat dissipation housing body
200A,200B,etc.: active heat dissipation apparatus
200A-1: first thermal conduction panel
200A-2: second thermal conduction panel
201: press-fitting edge
203: heat dissipation edge 241a,etc.: plurality of joint portions
251a,etc.: plurality of absorber retaining portions
260A,260B: absorber
T:reference line

### [Best Mode]

Hereinafter, embodiments of an active heat dissipation apparatus according to the present disclosure will be described in detail with reference to the attached drawings.

It should be noted that in assigning reference numerals of each drawing, like reference numerals refer to like elements as much as possible even though like elements are shown in different drawings. Furthermore, in the following description of embodiments of the present disclosure, detailed descriptions of related known configurations or functions will be omitted when it is determined that the detailed descriptions would obscure the understanding of the embodiments of the present disclosure.

In addition, the terms first, second, A, B, (a), and (b) may be used to describe elements of the embodiments of the present disclosure. These terms are used only for the purpose of discriminating one constituent element from another constituent element, and the nature, the sequences, or the orders of the constituent elements are not limited by the terms. Furthermore, unless otherwise defined, all terms used herein, including technical or scientific terms, have the same meaning as commonly understood by those skilled in the art to which the present disclosure pertains. The terms such as those defined in commonly used dictionaries should be interpreted as having meanings consistent with meanings in the context of related technologies and should not be interpreted as ideal or excessively formal meanings unless explicitly defined in the present application.

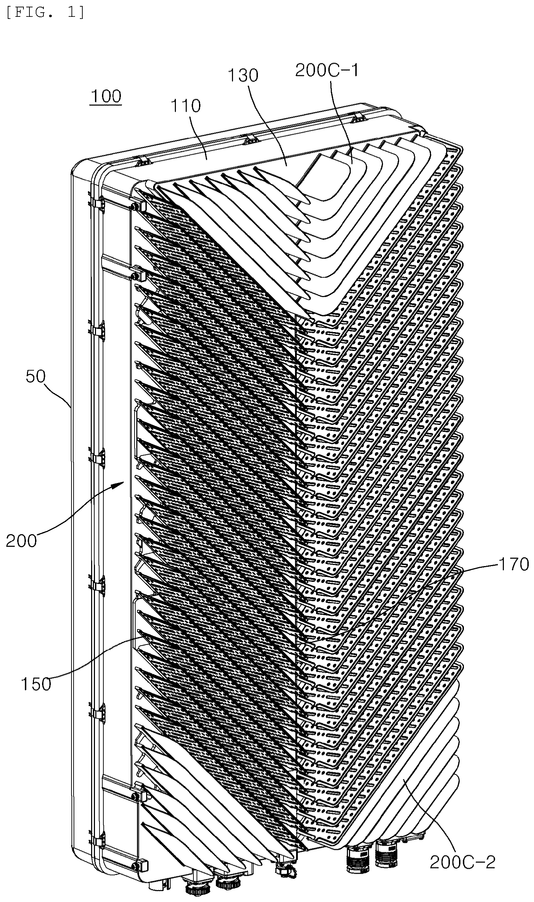

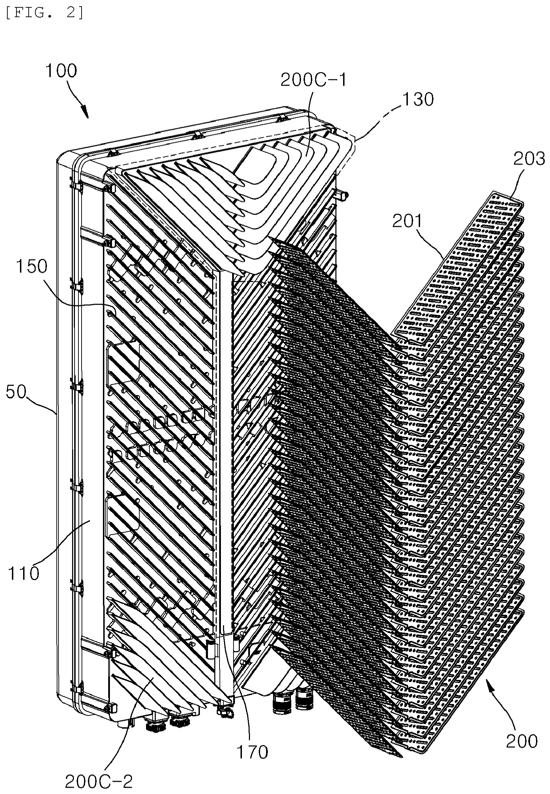

FIG. 1 is a perspective view illustrating an example of an active heat dissipation apparatus coupled to an antenna apparatus among electronic devices. FIG. 2 is an exploded perspective view illustrating a state in which the active heat dissipation apparatus is separated from the configuration of FIG. 1.

In general, an electronic device generates a certain amount of system-operating heat while operating electrically, and the performance of the electronic device depends on the rate at which the generated heat is dissipated. Representative examples of electronic devices, the performance of which is determined by the cooling rate, include semiconductors, as well as antenna apparatuses for communication, displays, batteries for electric vehicles, energy storage systems (ESS), artificial intelligence (AI) devices, and other electrical and electronic devices.

Hereinafter, for ease of understanding, an antenna apparatus among the above-described electronic devices will be described as a specific embodiment to which the present disclosure is applied.

As illustrated in FIG. 1, an antenna apparatus 100 to which an active heat dissipation apparatus 200 according to an embodiment of the present disclosure is applied includes a heat dissipation housing body 110 that forms a receiving space open toward the front and has a rectangular parallelepiped shape with a vertically elongated and thin front-rear receiving width.

Although not shown in the drawings, in the receiving space of the heat dissipation housing body 110, a main board may be stacked and disposed, which serves as a board for a power amplifier unit (PAU) and a digital transceiving unit (DTU), and includes a plurality of micro bellows filter (MBF) elements mounted on a front surface thereof via a clamshell, and certain heat-generating elements mounted on a rear surface thereof.

Here, a radio frequency integrated circuit (RFIC) element or power amplifier (PA) elements mounted on the main board may be defined as heat-generating elements that generate a large amount of heat during operation. However, in the embodiments of the present disclosure, it should be noted that the antenna apparatus is adopted as merely an example of the electronic device for the purpose of explanation, and the heat-generating elements are not limited to the foregoing configuration.

A radome panel 50 may be installed on a front side of the receiving space of the heat dissipation housing body 110, and may serve to protect radiation elements, which are implemented as antenna elements, from the outside, and also enable smooth radiation from the radiation elements.

The active heat dissipation apparatus 200 according to embodiments of the present disclosure may be installed on a rear surface of the heat dissipation housing body 110.

The active heat dissipation apparatus 200 according to embodiments of the present disclosure is provided in the form of a heat dissipation fin, and, more precisely, may be characterized in that it is provided as a vapor chamber type having a thin thickness and necessarily including an absorber that absorbs a liquid-phase portion of a refrigerant, unlike fixed heat dissipation fins 200C-1 and 200C-2 described below.

In general, a wick component having a wick structure with a plurality of pores is provided in a vapor chamber. However, the active heat dissipation apparatus 200 according to embodiments of the present disclosure is not limited to the wick component, and, in particular, as long as a liquid-phase refrigerant can be absorbed, it may encompass the concept of various types of absorbers, including an absorber made of a highly lightweight nonwoven fabric material that is easier to install and can raise a liquid (liquid-phase refrigerant) in a direction against gravity by a predetermined capillary phenomenon.

More specifically, a trench structure (170), which is open in a region that vertically partitions an exactly central portion between a left end and a right end of a rear surface of the heat dissipation housing body 110, may be provided on the rear surface of the heat dissipation housing body 110. The active heat dissipation apparatus 200 according to embodiments of the present disclosure may be arranged on both left and right sides of the trench structure (170) and obliquely inclined upward toward the left end and the right end.

A plurality of active heat dissipation apparatuses 200 according to embodiments of the present disclosure may be provided, and all may be formed in the same rectangular shape having an elongated length in the same longitudinal direction and having the same specifications. Accordingly, the fixed heat dissipation fins 200C-1 and 200C-2 may be disposed on portions of the rear surface of the heat dissipation housing body 110 that are not occupied by the active heat dissipation apparatuses 200.

The fixed heat dissipation fins 200C-1 and 200C-2 may include upper fixed heat dissipation fins 200C-1, which are disposed on an upper portion of the rear surface of the heat dissipation housing body 110 that is not occupied by the active heat dissipation apparatuses 200 according to embodiments of the present disclosure, as referenced in FIGS. 1 and 2, and lower fixed heat dissipation fins 200C-2, which are disposed on left and right lower portions of the rear surface of the heat dissipation housing body 110 that are not occupied by the active heat dissipation apparatuses 200 according to embodiments of the present disclosure.

A region where the trench structure 170 formed on the rear surface of the heat dissipation housing body 110 is provided, and a region (an inverted triangular region 130) where the upper fixed heat dissipation fins 200C-1 of the fixed heat dissipation fins 200C-1 and 200C-2 are installed, may be filled with the refrigerant. In other words, a refrigerant flow space (not shown) may be provided in the form of an embedded structure in the rear surface of the heat dissipation housing body 110 so that the refrigerant can be filled therein.

In this case, particularly, in the region corresponding to the trench structure (170), an absorber formed of either a nonwoven fabric or a nonwoven fabric coupled to a braided structure made of a copper wire may be provided, so that the liquid-phase refrigerant filled therein can be more easily vaporized by heat transferred from the heat-generating elements 140.

The refrigerant filled in the refrigerant flow space on the rear surface of the heat dissipation housing body 110 undergoes a phase change in which the refrigerant is vaporized into a gaseous state in a vaporization zone, which is located at a relatively lower position and defined by the trench structure 170, due to a temperature change caused by heat transferred from the heat-generating elements. Thereafter, the refrigerant in the vaporized state moves to the inverted triangular region 130, which serves as a condensation zone located at a relatively upper position, and in which the upper fixed heat dissipation fins 200C-1 are provided, and undergoes a phase change so that the refrigerant is condensed back into a liquid state. The refrigerant in the liquid state subsequently moves downward by gravity and capillary action, and this cycle is repeatedly performed to provide a heat dissipation function.

For reference, a refrigerant to be described later, which is filled in the active heat dissipation apparatuses 200 according to embodiments of the present disclosure, is independent of the refrigerant filled in the refrigerant flow space corresponding to the above-described inverted triangular region 130 and trench structure 170. The filled refrigerants may have the same specifications or different specifications depending on the level of heat generation and the mounting positions of the heat-generating elements.

As referenced in FIGS. 1 and 2, a press-fitting portion 150 may be formed on the rear surface of the heat dissipation housing body 110 to allow press-fitting installation of the plurality of active heat dissipation apparatuses 200 according to embodiments of the present disclosure.

As described above, due to the fact that the active heat dissipation apparatuses 200 according to embodiments of the present disclosure are arranged to be obliquely inclined upward toward the left and right ends with respect to the trench structure 170, a plurality of press-fitting portions 150 may also be provided, and may be arranged to form a 'V' shape with reference to the trench structure 170.

However, the structure for press-fitting installation of the active heat dissipation apparatuses 200 according to embodiments of the present disclosure on the rear surface of the heat dissipation housing body 110 is not necessarily limited to the form of the press-fitting portions 150. For example, an inner side of each press-fitting portion 150 may be formed as an installation hole that passes through the rear surface of the heat dissipation housing body 110 in a front-rear direction, such that a press-fitting edge 201 of the corresponding active heat dissipation apparatus 200 is directly brought into thermal contact with a heat generation surface of a heat-generating element.

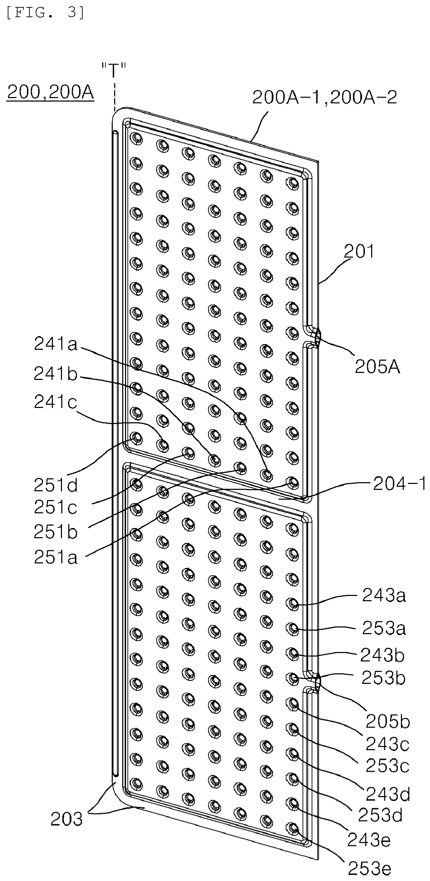

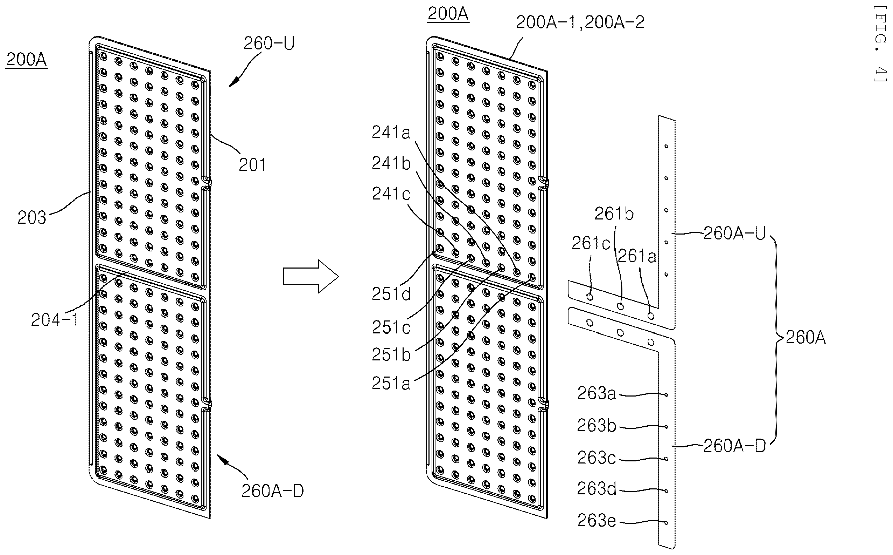

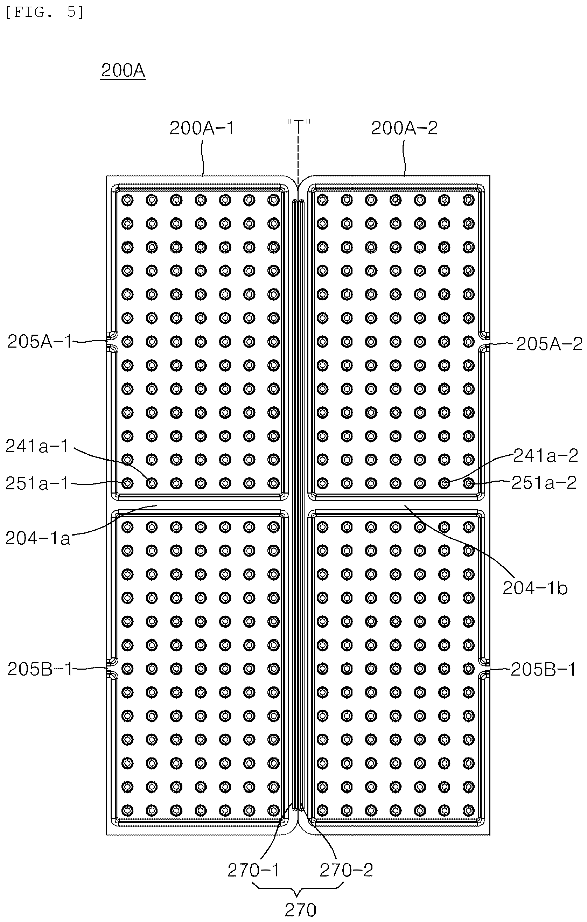

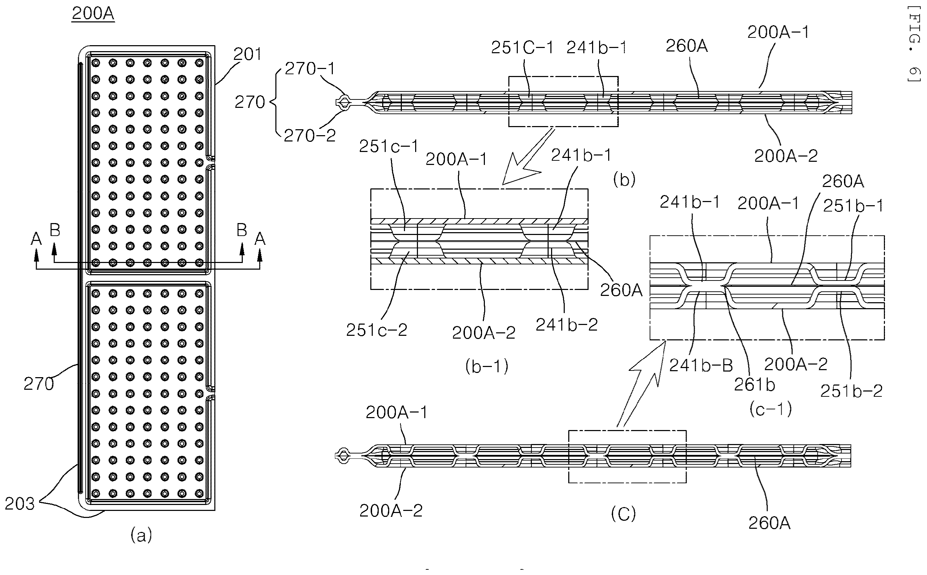

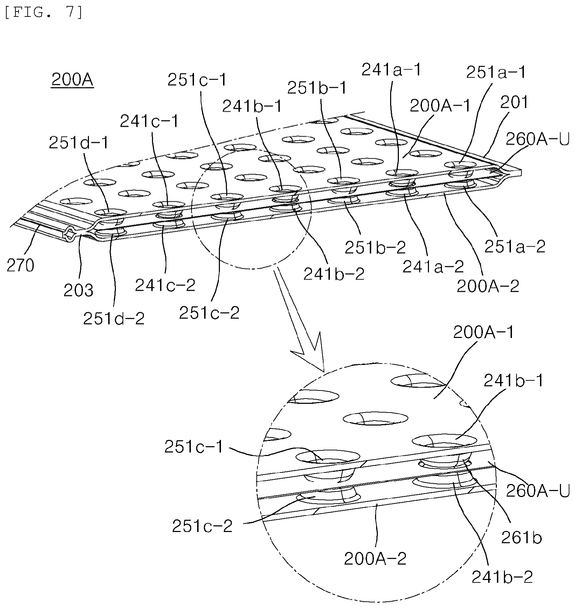

FIG. 3 is a perspective view illustrating an active heat dissipation apparatus according to an embodiment of the present disclosure. FIG. 4 is an exploded perspective view of FIG. 3. FIG. 5 is a developed view illustrating an unjoined state of FIG. 3. FIG. 6 is a front view (a) of FIG. 4, cross-sectional views (b) and (c) taken along lines A-A and B-B, and enlarged views of portions thereof. FIG. 7 is a sectional perspective view taken along line A-A of FIG. 6, and an enlarged view of a portion thereof.

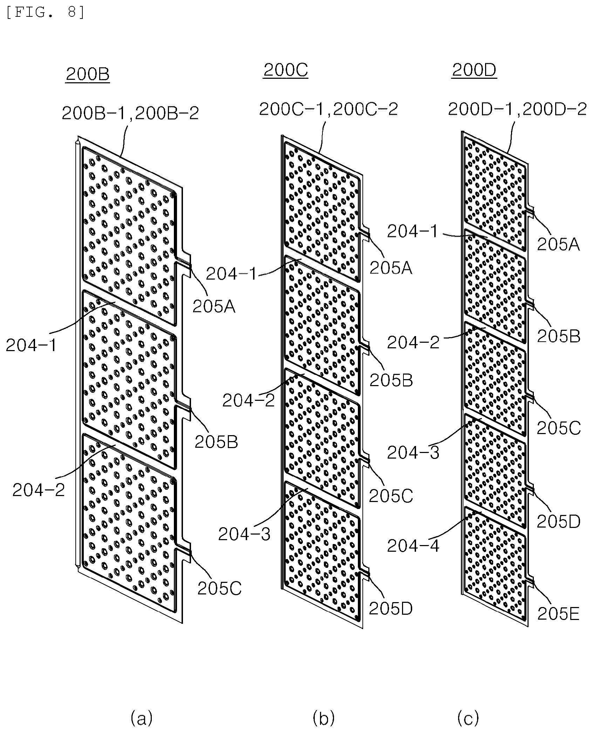

Referring to FIGS. 3 to 7, an active heat dissipation apparatus 200A according to an embodiment of the present disclosure includes a thermal conduction panel body (200A-1 and 200A-2) or (200B-1 and 200B-2), a plurality of joint portions (e.g., 241a) that join portions of the thermal conduction panel body to each other, an absorber 260, and a plurality of absorber retaining portions (e.g., 251a), as features common to an active heat dissipation apparatus 200B according to another embodiment of the present disclosure, which will be described with reference to FIGS. 8 to 11B. In the following description, to prevent confusion in understanding, common features of an embodiment 200A and another embodiment 200B will be described with reference numerals associated with the embodiment 200A.

As referred to in FIG. 5, the thermal conduction panel body (200A-1 and 200A-2) may be formed as a single component made of a thermally conductive material (e.g., a metal material), and may integrally include a first thermal conduction panel 200A-1 and a second thermal conduction panel 200A-2, which respectively form a first surface and a second surface of a thickness portion, by being bent to define a refrigerant flow space (not designated with a reference numeral) having a predetermined thickness in which a refrigerant is filled and flows.

However, the thermal conduction panel body (200A-1 and 200A-2) does not necessarily have to be formed of a single metal panel component and bent as described above to define the refrigerant flow space. In other words, the refrigerant flow space may also be formed by joining a first thermal conduction panel 200A-1 and a second thermal conduction panel 200A-2, which are formed of two separate metal panel components, to each other along peripheral edges thereof.

In the case where the refrigerant flow space is formed by the bending method described above, the refrigerant flow space may be formed by bending (folding) a single metal panel component such that one end of the first thermal conduction panel 200A-1 in a width direction and a corresponding end of the second thermal conduction panel 200A-2 in the width direction are joined to each other around a predetermined reference line T that divides the single metal panel component at its center into the first thermal conduction panel 200A-1 and the second thermal conduction panel 200A-2.

In the case of manufacturing using the above-described joining method, it may be understood that the refrigerant flow space is formed by directly joining the first thermal conduction panel 200A-1 and the second thermal conduction panel 200A-2, which are provided as two metal panel components, without a bending process.

In this case, in the refrigerant flow space, the first surface formed by the first thermal conduction panel 200A-1 and the second surface formed by the second thermal conduction panel 200A-2 may form a thickness portion having a predetermined thickness.

The refrigerant flow space may be defined as a space in which the refrigerant filled through refrigerant filling ports 205A and 205B to be described below flows. In the refrigerant flow space, when the liquid-phase refrigerant receives a predetermined amount of heat from heat-generating bodies (heat-generating elements), the refrigerant undergoes a phase change into a vapor phase and flows, exchanging heat with the external air through outer surfaces of the first thermal conduction panel 200A-1 and the second thermal conduction panel 200A-2, and then undergoes a phase change back into a liquid state, flowing down in the direction of gravity toward the heat-generating elements, and this flow is repeated.

As referred to in FIGS. 3 to 7, a plurality of joint portions (e.g., 241a) may be respectively formed on each of the first thermal conduction panel 200A-1 and the second thermal conduction panel 200A-2, and may serve to join the first thermal conduction panel 200A-1 and the second thermal conduction panel 200A-2 to each other in the refrigerant flow space during joining.

The plurality of joint portions (e.g., 241a) may be formed together when the thermal conduction panel body (200A-1 and 200A-2) is manufactured through a pressing process using a press die, with a base panel formed of a single metal panel component or a base panel formed of two metal panel components.

The absorber 260A may be disposed at an appropriate position in the refrigerant flow space, and may include a plurality of pores such that a liquid-phase refrigerant, which has undergone a phase change into a liquid state through heat exchange with external air, is absorbed into the absorber 260A and easily evaporated by heat transferred from the predetermined heat-generating elements, or, as will be described later, may serve to move the liquid-phase refrigerant in a direction opposite to the direction of gravity by a predetermined capillary phenomenon.

The absorber 260A may be implemented using a nonwoven fabric having a small thickness, but is not necessarily limited thereto, and may be implemented using any element as long as it satisfies the absorption rate of the liquid-phase refrigerant and the flow-driving force due to capillary action as described above.

In the active heat dissipation apparatus 200A according to an embodiment of the present disclosure, in the case where the refrigerant flow space is divided into upper and lower portions in the drawing by a chamber partition portion 204-1, as will be described later, the absorber 260A may be disposed in an L-shape or an inverted L-shape in each of the refrigerant flow spaces.

The absorbers 260A-U and 260A-D as described above may be disposed in portions of the respective refrigerant flow spaces, and may serve to activate refrigerant evaporation by transferring the liquid-phase refrigerant, which is relatively located on a lower side in the direction of gravity, to an upper side in the direction of gravity through capillary action so that the liquid-phase refrigerant can be uniformly distributed across the entire press-fitting edge 201 that is close to the heat-generating portions of the heat-generating elements.

The plurality of absorber retaining portions (e.g., 251a), which are provided in the refrigerant flow space, may be provided on at least one of the first thermal conduction panel 200A-1 and the second thermal conduction panel 200A-2, as referred to in FIGS. 6 and 7, and may serve to retain the absorber 260A in place.

In the same manner as the plurality of joint portions (e.g., 241a) described above, the plurality of absorber retaining portions (e.g., 251a) may also be formed together when the thermal conduction panel body (200A-1 and 200A-2) is manufactured through a pressing process using a press die, with a base panel formed of a single metal panel component or a base panel formed of two metal panel components.

As referred to in FIGS. 3 to 7, the plurality of joint portions (e.g., 241a) may be provided such that, when the refrigerant flow space is formed through the bending process, the joint portions (e.g., 241a) on the respective opposite surfaces of the first thermal conduction panel 200A-1 and the second thermal conduction panel 200A-2 protrude toward each other in directions corresponding to the refrigerant flow space.

The plurality of joint portions (e.g., 241a) as described above may be formed such that respective tip surfaces of the portions thereof protruding toward each other come into surface contact with each other at a middle portion of the thickness portion of the refrigerant flow space. The surface contact portions may be joined to each other by various joining methods such as welding. The joining method is not limited to welding, but when welding is adopted, laser welding may be preferred.

The plurality of joint portions (e.g., 241a) may be joined to each other by passing through the absorber 260A, which is provided in the refrigerant flow space, in the thickness direction, such that the respective tip surfaces thereof come into surface contact and are joined with each other by a predetermined joining method, as described above. To this end, a plurality of joint through-holes 261b may be formed in the absorber 260A to allow the plurality of joint portions (e.g., 241a) to pass through the absorber 260A and come into surface contact with each other.

In this case, it is preferable that the size of the plurality of joint through-holes 261b be formed larger than at least the diameter of the respective tip surfaces of the plurality of joint portions (e.g., 241a), so as to prevent the joint through-holes 261b from being affected by the welding heat generated when the joint portions (e.g., 241a) are welded while the first thermal conduction panel 200A-1 and the second thermal conduction panel 200A-2 are joined to each other.

Unlike this, in some embodiments, because the plurality of absorber retaining portions (e.g., 251a) are provided so as to support the absorber 260A without penetrating one surface of the absorber 260A, the absorber 260A may not necessarily include a hole for penetration of the plurality of absorber retaining portions (e.g., 251a).

However, in other embodiments (e.g., 200B) of the present disclosure to be described later, in the case where two absorbers 260B-a and 260B-b are provided and one of a plurality of absorber retaining portions 251-1 and 251-2 is provided so as to penetrate an absorber provided adjacent thereto, it is apparent that a separate hole for the penetration may be provided. A more detailed description thereof will be provided later.

The plurality of joint portions (e.g., 241a) and the plurality of absorber retaining portions (e.g., 251a) may be alternately and repeatedly arranged at intervals to be aligned in a straight line direction of the thermal conduction panel body (200A-1 and 200A-2), as referred to in FIGS. 3 to 5.

More specifically, with focus on the portion where the absorber 260A is substantially installed in the active heat dissipation apparatus 200A according to an embodiment of the present disclosure, the thermal conduction panel body (200A-1 and 200A-2) is provided such that the opposite surfaces of the thickness portion having a predetermined thickness respectively form heat dissipation surfaces with the first thermal conduction panel 200A-1 and the second thermal conduction panel 200A-2, as referred to in FIG. 3.

Here, a plurality of joint portions 241a to 241c may be arranged on each of the first thermal conduction panel 200A-1 and the second thermal conduction panel 200A-2 to be spaced apart from each other by a predetermined distance in a "column" direction, which is a left-right direction in the drawing. Similarly, a plurality of joint portions 243a to 243e may be arranged to be spaced apart from each other by a predetermined distance in a "row" direction, which is a vertical direction in the drawing.

In addition, a plurality of absorber retaining portions 251a to 251d may be arranged on each of the first thermal conduction panel 200A-1 and the second thermal conduction panel 200A-2 to be spaced apart from each other by a predetermined distance in the "column" direction, which is the left-right direction in the drawing, and may be arranged alternately between the respective joint portions 241a to 241c arranged in the "column" direction among the above-described plurality of joint portions (e.g., 241a) (or may be arranged on the last column thereof). Likewise, a plurality of absorber retaining portions 253a to 253e may be arranged to be spaced apart from each other by a predetermined distance in the "row" direction, which is the vertical direction in the drawing, and may be arranged alternately between the respective joint portions 243a to 243e arranged in the "row" direction among the above-described plurality of joint portions (e.g., 241) (or may be arranged on the last row thereof).

In particular, in the active heat dissipation apparatus 200A according to an embodiment of the present disclosure, regardless of the plurality of joint portions (e.g., 241a), the plurality of absorber retaining portions (e.g., 251a) do not need to be provided over the entire areas of the first thermal conduction panel 200A-1 and the second thermal conduction panel 200A-2.

For example, as referred to in FIG. 4, at least one end of the thermal conduction panel body (200A-1 and 200A-2), in a state where the first thermal conduction panel 200A-1 and the second thermal conduction panel 200A-2 are joined, may form a press-fitting edge 201 that is disposed adjacent to the heat-generating elements, which are heat dissipation targets. Here, the press-fitting edge 201 may be defined as an end provided at a relatively lower position based on the direction of gravity. In this case, it is sufficient for at least a portion of the absorber 260A to be disposed linearly along the press-fitting edge 201.

Accordingly, it is sufficient that, in the refrigerant flow space, the plurality of absorber retaining portions (e.g., 251a) that retain the absorber 260A in place are formed only in regions where the absorber 260A is disposed.

In other words, as referred to in FIG. 4, when the absorber 260A is disposed to be elongated in the "row" direction adjacent to the press-fitting edge 201 and is formed to be elongated in the "column" direction on a lower or upper end, the plurality of absorber retaining portions (e.g., 251a) may be formed only in the region where the absorber 260A is disposed.

Furthermore, in the active heat dissipation apparatus 200A according to an embodiment of the present disclosure, the plurality of joint portions (e.g., 241a) may be uniformly distributed and arranged on both the first thermal conduction panel 200A-1 and the second thermal conduction panel 200A-2, and may be evenly joined to each other after the bending (folding) process, thereby preventing deformation caused by internal pressure of the refrigerant flow space.

When a region of each of the first thermal conduction panel 200A-1 and the second thermal conduction panel 200A-2 excluding the press-fitting edge 201 is defined as a heat dissipation plate portion (not designated with a reference numeral), a remaining region of the absorber 260A may be bent and linearly extended toward a region of the heat dissipation plate portion that is located at a relatively lower side with respect to the direction of gravity.

For instance, when the active heat dissipation apparatus 200A according to an embodiment of the present disclosure is provided in a rectangular shape having a length in the vertical direction greater than a width in the front-rear direction, the absorber 260A may be formed to extend along the press-fitting edge 201, which is one of the ends in the width direction. The absorber 260A may then be bent horizontally at a lower end in the vertical direction, which is located at a relatively lower side with respect to the direction of gravity, and extend rearward by a predetermined length, so as to be disposed in an approximately L-shape or an inverted L-shape.

The active heat dissipation apparatus 200A according to an embodiment of the present disclosure may have a distinguishing feature in that, unlike other embodiments (e.g., 200B) to be described later, the absorber 260A is spaced apart from and disposed parallel to the first thermal conduction panel 200A-1 and the second thermal conduction panel 200A-2 at an intermediate position in the thickness portion of the refrigerant flow space.

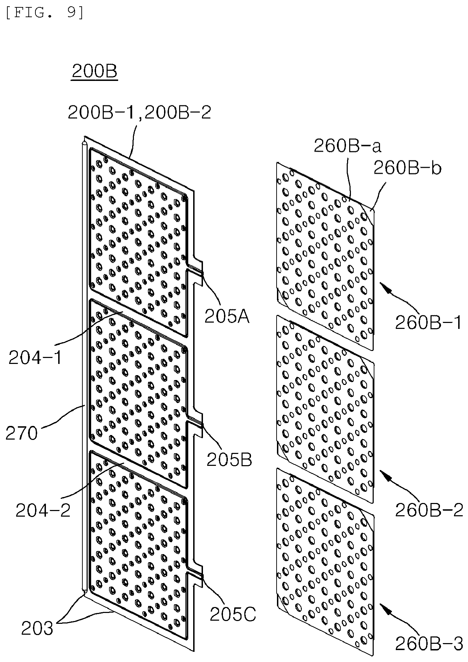

The active heat dissipation apparatus 200B according to another embodiment of the present disclosure is distinguished from the active heat dissipation apparatus 200A according to an embodiment of the present disclosure, in that an absorber is divided into two elements including a first absorption element 260B-a and a second absorption element 260B-b (see FIG. 9), and the first absorption element 260B-a is disposed in close contact with an inner surface of a first thermal conduction panel 200B-1 in the refrigerant flow space, and the second absorption element 260B-b is disposed in close contact with an inner surface of a second thermal conduction panel 200B-2 in the refrigerant flow space. The active heat dissipation apparatus 200B according to another embodiment of the present invention will be described in more detail below.

In the case of the active heat dissipation apparatus 200A according to an embodiment of the present disclosure, in which the absorber 260A is disposed at the intermediate position in the thickness portion of the refrigerant flow space, when system heat is transferred thereto from the heat-generating elements adjacent to the press-fitting edge 201, a portion of the absorber 260A located close to the press-fitting edge 201 performs a role of absorbing and storing a maximum amount of liquid-phase refrigerant to promote phase change of the refrigerant into a vapor-phase.

In addition, a portion of the absorber 260A that is spaced apart from the press-fitting edge 201 and disposed relatively closer to a heat dissipation edge 203 performs a role of providing a location at which vapor-phase refrigerant, after undergoing heat exchange through the inner surfaces of the first thermal conduction panel 200A-1 and the second thermal conduction panel 200A-2, can be immediately condensed and absorbed during phase change into liquid-phase refrigerant, thereby maximizing heat transfer capability.

Here, when liquid-phase refrigerant, resulting from phase change due to condensation of vapor-phase refrigerant, is absorbed into the absorber 260A, the liquid-phase refrigerant may flow downward in the direction of gravity and return toward the press-fitting edge 201, whereby the overall heat transfer capability of the refrigerant may be significantly improved.

Furthermore, in the case where a chamber partition portion 204-1, which will be described later, partitions the refrigerant flow space into a predetermined number of spaces and the absorbers 260A-U and 260A-D are disposed in the respective refrigerant flow spaces, it is possible to overcome the heat transfer capability limit and boiling limit of the refrigerant, shorten the evaporation time in the evaporation zone and the condensation time in the condensation zone, increase the number of phase change cycles of the refrigerant as a whole, and thereby create an advantage of accelerating heat dissipation.

As referred to in FIGS. 6 and 7, in the active heat dissipation apparatus 200A according to an embodiment of the present disclosure, when an edge opposite to the above-described press-fitting edge 201 is defined as a heat dissipation edge 203, a rigidity rib 270 for increasing structural rigidity may be formed along the heat dissipation edge 203 by machining.

Similarly to the formation of the plurality of joint portions (e.g., 241a) and the plurality of absorber retaining portions (e.g., 251a), the rigidity rib 270 may also be formed together when the thermal conduction panel body (200A-1 and 200A-2) is manufactured through a pressing process using a press die, with a base panel formed in a single metal panel shape.

The rigidity rib 270 performs a role of enhancing rigidity to prevent bending deformation caused by external pressure that may occur in the case where the active heat dissipation apparatus 200A according to an embodiment of the present disclosure is attached in the form of a heat dissipation fin to the rear surface of the heat dissipation housing body 110.

As referred to in FIG. 6, the rigidity rib 270 may include a first rigidity rib groove 270-1 formed to be recessed from the first thermal conduction panel 200A-1 toward an outer side of the refrigerant flow space, and a second rigidity rib groove 270-2 formed to be recessed from the second thermal conduction panel 200A-2 toward the outer side of the refrigerant flow space.

The first rigidity rib groove 270-1 and the second rigidity rib groove 270-2 may be formed to be symmetrical with each other, thus forming a predetermined closed-loop cross-section when the first thermal conduction panel 200A-1 and the second thermal conduction panel 200A-2 are joined to overlap each other.

As referred to in FIG. 3, the active heat dissipation apparatus 200A according to an embodiment of the present disclosure may further include at least one chamber partition portion 204-1.

The chamber partition portion 204-1 may be provided on the first thermal conduction panel 200A-1 and the second thermal conduction panel 200A-2, and may function to partition the refrigerant flow space into at least two or more sections when the first thermal conduction panel 200A-1 and the second thermal conduction panel 200A-2 are joined to each other.

As in embodiments of the active heat dissipation apparatus (e.g., 200A) according to the present disclosure, when the interior thereof is filled with a refrigerant and heat dissipation is performed through heat transfer (thermal flow) via phase change of the refrigerant, it is apparent that the performance improves as the thickness becomes slimmer and the heat dissipation area becomes larger. However, due to the limit of the heat transfer capability of the refrigerant itself, increasing the heat dissipation area, i.e., enlarging the surface area, has inevitably faced limitations.

Here, the above-described chamber partition portion 204-1 enables realization of surface area enlargement while maintaining overall heat dissipation performance within the inherent heat transfer capability of the refrigerant, by separating the refrigerant flow space into multiple chambers each of which is filled with a respective refrigerant, taking into account maximization of the heat dissipation area and the heat transfer capability of the refrigerant.

As referred to in FIGS. 3 to 7, the chamber partition portion 204-1 may be provided as a single structure extending in a left-right direction in the drawing such that the refrigerant flow space filled with refrigerant is vertically divided into two refrigerant flow spaces, which are respectively located at upper and lower positions in the drawing. Alternatively, as in other embodiments (200B, 200C, 200D) described later, two (204-1 and 204-2), three (204-1 to 204-3), or four (204-1 to 204-4) chamber partition portions may be provided.

In this case, it is apparent that refrigerant filling ports (e.g., 205A), through which refrigerant can be filled into the respective refrigerant flow spaces, may also be formed in a number corresponding to the number of chambers.

The chamber partition portion 204-1 includes a first chamber partition rib 204-1a formed on the first thermal conduction panel 200A-1 and a second chamber partition rib 204-1b formed on the second thermal conduction panel 200A-2. When the thermal conduction panel bodies 200A-1 and 200A-2 are joined, the first chamber partition rib 204-1a and the second chamber partition rib 204-1b may be brought into surface contact with each other and may be completely partitioned from adjacent refrigerant flow spaces.

Furthermore, as referred to in FIG. 4, in the case where the refrigerant flow space is partitioned into two spaces by the chamber partition portion 204-1, the absorber 260A may also be provided in two units (see reference numerals 260A-U and 260A-D in FIG. 4), corresponding to the number of refrigerant flow spaces formed by the chamber partition portion 204-1.

This is the same principle as in another embodiment (200B) of the present disclosure, which will be described later (see FIG. 9), where the refrigerant flow space is partitioned into three spaces by two chamber partition portions 204-1 and 204-2, and three absorbers 260B-1 to 260B-3 are provided accordingly.

Moreover, as referred to in (b) of FIG. 8, the refrigerant flow space may be partitioned into four spaces by three chamber partition portions 204-1, 204-2, and 204-3, and as referred to in (c) of FIG. 8, the refrigerant flow space may be partitioned into five spaces by four chamber partition portions 204-1 to 204-4. In this case, it is apparent that one absorber may be disposed in each of the refrigerant flow spaces.

The design of the number of chamber partition portions (e.g., 204-1) and the number of refrigerant flow spaces may be determined in consideration of the heat transfer capability of the selected refrigerant, as described above, and may serve as a critical factor in reducing the amount of protrusion toward the rear surface of the heat dissipation housing body 110.

As described above, when a plurality of refrigerant flow spaces are partitioned and formed by the chamber partition portions (e.g., 204-1), refrigerant filling ports (e.g., 205A) for filling refrigerant may also be formed in a number corresponding to the number of refrigerant flow spaces.

The active heat dissipation apparatus 200A according to an embodiment of the present disclosure and the active heat dissipation apparatus 200B according to another embodiment of the present disclosure, which will be described later, may further include a caulking element (not shown) that is inserted, after the refrigerant flow space is filled with refrigerant, into each of the refrigerant filling ports (e.g., 205A) and seals the refrigerant flow space by crimping the refrigerant filling port (e.g., 205A), although not shown in the drawings.

The caulking element is made of a material that undergoes deformation by an external force, and performs a function of preventing leakage of the internal refrigerant by being compressed through a caulking process that crimps an inlet region of the refrigerant filling port (e.g., 205A) from the outside.

Before the caulking process of sealing the inlet region of the refrigerant filling port (e.g., 205A) using the caulking element, a vacuuming process of depressurizing the refrigerant flow space to create a vacuum may be performed in advance.

After the caulking element is inserted into the refrigerant filling port (e.g., 205A), the refrigerant filling port (e.g., 205A) including the caulking element may be cut to match an outer end of the press-fitting edge 201, so as to facilitate smooth interference-type press-fitting into the above-described press-fitting portion 150.

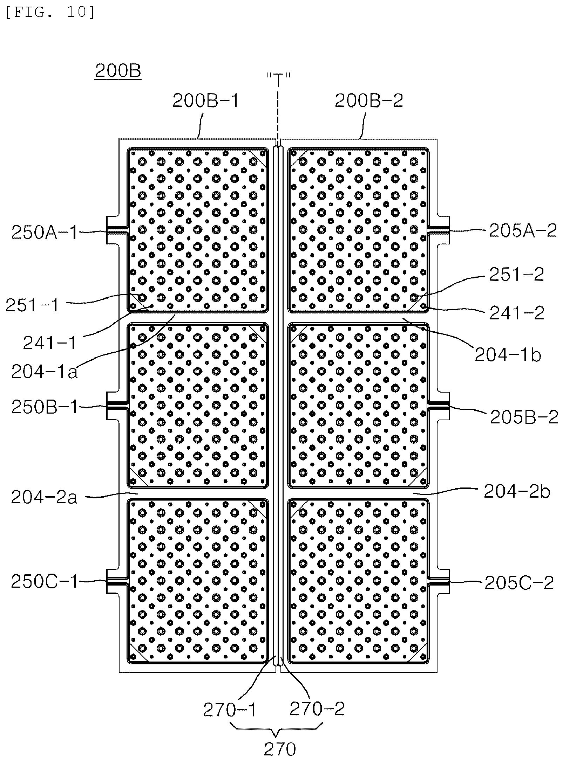

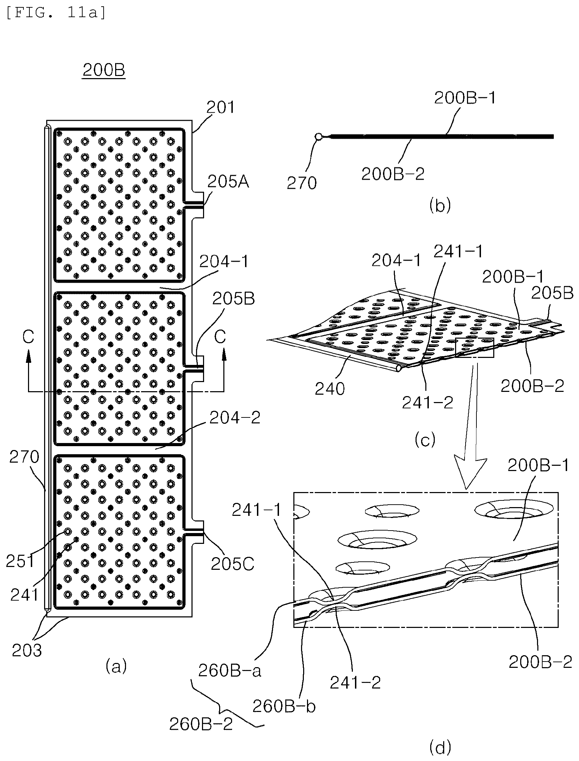

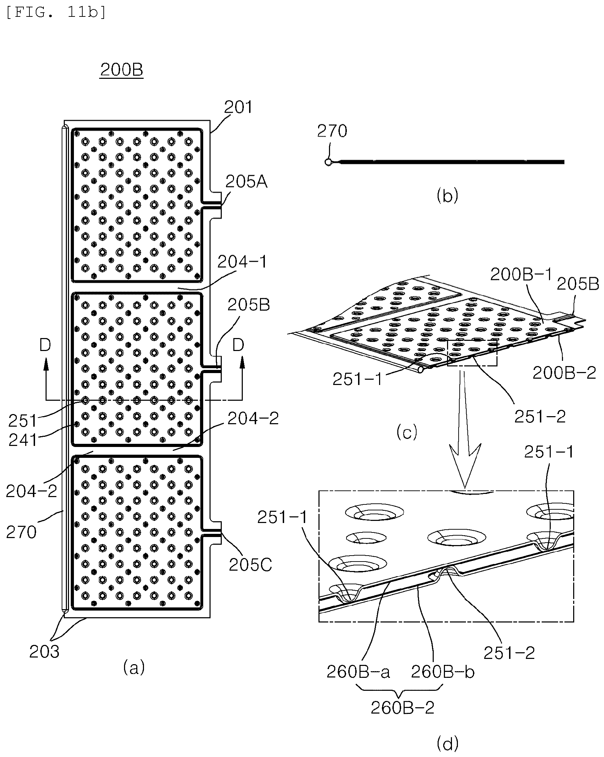

FIG. 8 illustrates perspective views of active heat dissipation apparatuses according to other embodiments 200B, 200C, and 200D of the present disclosure. FIG. 9 is an exploded perspective view of another embodiment 200B referred to as (a) in FIG. 8. FIG. 10 is a developed view illustrating an unjoined state of another embodiment 200B referred to as (a) in FIG. 8. FIG. 11a illustrates a front view (a) of another embodiment 200B referred to as (a) in FIG. 8, a cross-sectional view (b) and a sectional perspective view (c) taken along line C-C, and an enlarged view (d) of a portion thereof. FIG. 11b illustrates a front view (a) of another embodiment 200B referred to as (a) in FIG. 8, a cross-sectional view (b) and a sectional perspective view (c) taken along line D-D, and an enlarged view (d) of a portion thereof.

Other embodiments 200B, 200C, and 200D of the present disclosure, as illustrated in FIG. 8, are embodiments implemented in different ways based on the number of refrigerant flow spaces partitioned by the chamber partition portions (e.g., 204-1). Hereinafter, a detailed description of technical features common to the embodiment 200A of the present disclosure described above is omitted, and only technical features that are different therefrom will be described.

In addition, among other embodiments of the present disclosure, the embodiment indicated by reference numeral 200B and the embodiments indicated by reference numerals 200C and 200D are identical in configuration except for the number of refrigerant flow spaces. Therefore, only the embodiment indicated by reference numeral 200B will be described in detail below with reference to the drawings.

As illustrated in FIGS. 8 to 11B, an active heat dissipation apparatus 200B according to another embodiment of the present disclosure may be implemented with an absorber 260B formed of two elements, including a first absorption element 260B-a and a second absorption element 260B-b.

More specifically, the absorber 260B may include the first absorption element 260B-a disposed in close contact with an inner surface of the first thermal conduction panel 200B-1 in the refrigerant flow space, and the second absorption element 260B-b disposed in close contact with an inner surface of the second thermal conduction panel 200B-2 in the refrigerant flow space.

As described above, the active heat dissipation apparatus 200B according to another embodiment of the present disclosure has an advantage of maximizing the return transport capability of the refrigerant by dividing the absorber 260B, which exhibits heat transfer capability based on capillary force, into two elements and respectively disposing the two elements on the first thermal conduction panel 200B-1 and the second thermal conduction panel 200B-2.

Here, the return transport capability of the refrigerant may refer to a rapid return rate of the liquid-phase refrigerant toward the press-fitting edge 201 due to phase change. Improvement in the return transport capability of the refrigerant leads to an advantage of preventing a dry-out phenomenon of the absorber 260B.

Unlike the active heat dissipation apparatus 200A according to an embodiment of the present disclosure, in which the single absorber 260A is provided as a single element and is spaced apart and disposed parallel to the inner surfaces of the first thermal conduction panel 200A-1 and the second thermal conduction panel 200A-2 at an intermediate position in the thickness portion of the refrigerant flow space, the active heat dissipation apparatus 200B according to another embodiment of the present disclosure includes two absorbers 260B-a and 260B-b that are disposed in close contact with the inner surfaces of the first thermal conduction panel 200B-1 and the second thermal conduction panel 200B-2, respectively.

Furthermore, in the active heat dissipation apparatus 200B according to another embodiment of the present disclosure, as referred to in FIGS. 11A and 11B, a plurality of absorber retaining portions 251-1 and 251-2 may include a first absorber retaining portion 251-1 protruding from the first thermal conduction panel 200B-1 toward the second thermal conduction panel 200B-2, and a second absorber retaining portion 251-2 protruding from the second thermal conduction panel 200B-2 toward the first thermal conduction panel 200B-1.

The first absorber retaining portion 251-1 may protrude through the first absorption element 260B-a to support the second absorption element 260B-b. The second absorber retaining portion 251-2 may protrude through the second absorption element 260B-b to support the first absorption element 260B-a.

Accordingly, a retaining portion through-hole (not designated with a reference numeral) may be formed in each of the first absorption element 260B-a and the second absorption element 260B-b, to allow the second absorber retaining portion 251-2 and the first absorber retaining portion 251-1 to pass therethrough, respectively.

In the embodiment 200A of the present disclosure, a plurality of joint portions (e.g., 241a) and a plurality of absorber retaining portions (e.g., 251a) are spaced apart and arranged alternately in a matrix form (rows and columns) on opposite surfaces of the thermal conduction panel body (200A-1 and 200A-2). However, in the active heat dissipation apparatus (e.g., 200B) according to other embodiments of the present disclosure, a plurality of joint portions 241 and a plurality of absorber retaining portions 251 may be spaced apart and arranged alternately and repeatedly along left and right diagonal directions, rather than in the vertical direction (rows) or horizontal direction (columns) as shown in FIG. 11a.

In addition, the first absorption element 260B-a and the second absorption element 260B-b may be formed with a plurality of joint through-holes (not designated with a reference numeral; see reference numeral 261b in FIG. 6), so as to prevent thermal damage when the plurality of joint portions 241 are joined to each other.

Unlike in the embodiment 200A in which the absorber 260A is disposed only in a portion adjacent to the press-fitting edge 201, in the active heat dissipation apparatus 200B according to another embodiment of the present disclosure, the first absorption element 260B-a and the second absorption element 260B-b may be disposed over an entire area of the refrigerant flow space corresponding to the heat dissipation plate portion, which is a remaining portion other than the press-fitting edge 201.

As the absorber 260B is uniformly supported using the plurality of joint portions 241 evenly distributed on the first thermal conduction panel 200B-1 and the second thermal conduction panel 200B-2, and the plurality of absorber retaining portions (e.g., 251a) simultaneously formed during a pressing process, there is an advantage in that the absorber 260B can be reliably retained in place in the refrigerant flow space without the need for separate additional retaining elements.

For example, in the case where separate elements such as a spacer, pillar, wire, powder, or screen mesh are employed to retain the absorber (260B, including the absorber 260A according to an embodiment) in place, separate additional joining, sintering, bonding, or planarization processes are required. However, since the absorber can be reliably retained using the plurality of joint portions 241 and the plurality of absorber retaining portions 251 that are formed together during the pressing process of the thermal conduction panel body, there is an advantage in that the number of components can be reduced, the number of processes can be reduced, and surface area enlargement of the active heat dissipation apparatus 200A or 200B itself can be achieved.

In the active heat dissipation apparatus (e.g., 200A or 200B) according to embodiments of the present disclosure, the press-fitting edge 201 may be forcibly coupled in a press-fitting manner to a corresponding one of the plurality of press-fitting portions 150 formed on the rear surface of the heat dissipation housing body 110, as referred to in FIGS. 1 and 2.

Although not illustrated in the drawings, it is preferable that the press-fitting portion 150 be subjected to thermal epoxy treatment before the press-fitting, in order to improve heat transfer efficiency. Even when the press-fitting portion 150 is provided in the form of the above-described installation hole rather than in the form of the press-fitting portion, the thermal epoxy treatment process may also be additionally performed on surfaces of the heat-generating elements.

As such, the active heat dissipation apparatus (e.g., 200A or 200B) according to embodiments of the present disclosure is configured such that refrigerant is filled in the refrigerant flow space through which internal refrigerant flows, and an absorber similar to a wick component provided in a vapor chamber, which is a known heat dissipation component, is internally provided. Accordingly, the active heat dissipation apparatus do not merely serve as a known heat dissipation fin, but establish an active heat transfer system based on phase change of the refrigerant, thereby providing an advantage of maximizing heat dissipation performance by overcoming the limitations of the thermally conductive material of conventional heat dissipation fins.

Here, the closer to the press-fitting edge 201, the more actively the phase change of the liquid-phase refrigerant into vapor-phase refrigerant of a gaseous state occurs due to the heat transferred from the heat-generating elements. Accordingly, it is preferable that the absorber be installed as close as possible to the press-fitting edge 201.

However, the absorber does not necessarily have to be installed only in proximity to the press-fitting edge 201, and it is also apparent that the absorber may be installed in a uniformly distributed manner throughout the entire evaporation zone where the refrigerant may evaporate.

Referring to FIGS. 1 and 2, since the press-fitting portions 150 formed on the rear surface of the heat dissipation housing body 110 are arranged in a V-shape such that each of the press-fitting portions 150 is inclined upward toward one end in the left-right width direction with respect to the trench structure 170, the active heat dissipation apparatus (e.g., 200A or 200B) according to embodiments of the present disclosure may also have distinguishable "upper" and "lower" regions when the press-fitting edge 201 is fixed to the press-fitting portion 150. The upper region refers to a position relatively above with respect to the direction of gravity, and the lower region refers to a position relatively below with respect to the direction of gravity.

Heat generated from the heat-generating elements is primarily transferred to the press-fitting edge 201, and the liquid-phase refrigerant absorbed in the absorber 260A or 260B undergoes a phase change into vapor-phase refrigerant by the transferred heat. The vapor-phase refrigerant then actively flows throughout the entire refrigerant flow space, exchanges heat with external air through outer surfaces of the first thermal conduction panel 200A-1 or 200B-1, which includes the heat dissipation edge 203, and the second thermal conduction panel 200A-2 or 200B-2, and is then condensed again into liquid-phase refrigerant through a phase change.

The refrigerant that has undergone phase change into a liquid state is absorbed into the absorber 260A or 260B, moves downward in the direction of gravity to the lower region, and then moves again toward the press-fitting edge 201, which serves as a kind of evaporation zone. By repeating the above-described phase change, a system for dissipating heat generated from the heat-generating elements is established.

In the active heat dissipation apparatus (e.g., 200A or 200B) according to embodiments of the present disclosure, SUS material may be selected as the material of the base panel forming the thermal conduction panel body.

As such, in the case where the SUS material is selected as the material of the base panel, distilled water may also be adopted as the refrigerant to be filled therein, and a refrigerant having high latent heat and sensible heat, such as distilled water, can be used. Accordingly, an advantage of increased diversity in the selection of materials for the absorber 260A or 260B may be achieved due to the excellent surface tension characteristics.

For reference, among various types of refrigerants, H₂O (distilled water) has advantages over other refrigerants in terms of cost, heat of vaporization, and surface tension. However, in the case of aluminum, which is used as a material for typical heat dissipation fins, it is difficult to use distilled water because the distilled water causes chemical reactions.

The above description has illustrated, by way of example, a case in which the active heat dissipation apparatus (e.g., 200A or 200B) according to embodiments of the present disclosure is applied to the heat dissipation housing body 110 of an antenna device, which is a representative device of an electronic device.

However, the active heat dissipation apparatus (e.g., 200A or 200B) according to embodiments of the present disclosure is not necessarily limited to being applied only to antenna devices, and although not illustrated in the drawings, may also be applied as a medium that physically connects a battery of an electric vehicle and a refrigerant module that cools the battery. In addition, the active heat dissipation apparatus may be applied as a heat dissipation fin for display devices or televisions (TVs) with significant heat generation, and may also be used as cooling elements for energy storage systems (ESSs), semiconductors, artificial intelligence (AI) devices, and the like, thereby enabling very high versatility.

In particular, because the first thermal conduction panel 200A-1 or 200B-1 and the second thermal conduction panel 200A-2 or 200B-2, which have heat dissipation surfaces capable of being brought into wide-area direct contact with high-density, highly integrated, high-performance, and cutting-edge semiconductor devices with considerable heat generation characteristics, can be actively utilized, there is an advantage in that a natural cooling system can be easily established without using other electrical components such as a compressor.

This may also be utilized as a heat dissipation solution for various system chips such as insulated gate bipolar transistors (IGBTs), field programmable gate arrays (FPGAs), power integrated circuits (ICs), drive ICs, central processing units (CPUs), and graphics processing units (GPUs), and has the effect of reducing the overall weight and volume of the product.

Embodiments of the active heat dissipation apparatus according to the present disclosure have been described in detail with reference to the accompanying drawings. However, the present disclosure is not necessarily limited by the embodiments, and various modifications of the embodiments and any other embodiments equivalent thereto may of course be carried out by those skilled in the art to which the present disclosure pertains. Accordingly, the true protection scope of the present disclosure should be determined by the appended claims.

### [Industrial Applicability]

The present disclosure may provide an active heat dissipation apparatus capable of improving heat dissipation performance by actively transferring heat generated from a heat-generating device (e.g., an electronic device) through a phase change of a refrigerant, which is more effective than heat transfer based on the thermal conductivity of the heat dissipation apparatus itself.

## Claims

1. An active heat dissipation apparatus, comprising:
a thermal conduction panel body made of a thermally conductive material, and forming a refrigerant flow space with a predetermined thickness in which a refrigerant is filled and flows, the thermal conduction panel body comprising a first thermal conduction panel and a second thermal conduction panel that respectively form a first surface and a second surface of a thickness portion;
a plurality of joint portions respectively formed on the first thermal conduction panel and the second thermal conduction panel, and configured to join the first thermal conduction panel and the second thermal conduction panel to each other in the refrigerant flow space; and
an absorber disposed in the refrigerant flow space and configured to absorb a liquid-phase portion of the refrigerant,
wherein the plurality of joint portions pass through the absorber in a thickness direction and are joined to each other.

2. The active heat dissipation apparatus of claim 1, further comprising a plurality of absorber retaining portions provided on at least one of the first thermal conduction panel and the second thermal conduction panel and configured to retain the absorber in place.

3. The active heat dissipation apparatus of claim 2, wherein the plurality of absorber retaining portions are disposed to support an outer side of at least one of a first side surface and a second side surface of the absorber.

4. The active heat dissipation apparatus of claim 2, wherein the absorber is spaced apart from and disposed parallel to the first thermal conduction panel and the second thermal conduction panel at an intermediate position in the thickness portion of the refrigerant flow space.

5. The active heat dissipation apparatus of claim 4, wherein, among the plurality of absorber retaining portions, the absorber retaining portion formed on the first thermal conduction panel supports the first side surface of the absorber facing the first thermal conduction panel, out of the first side surface and the second side surface of the absorber, and
wherein, among the plurality of absorber retaining portions, the absorber retaining portion formed on the second thermal conduction panel supports the second side surface of the absorber facing the second thermal conduction panel, out of the first side surface and the second side surface of the absorber.

6. The active heat dissipation apparatus of claim 4, wherein the plurality of absorber retaining portions include a first absorber retaining portion protruding from the first thermal conduction panel toward the second thermal conduction panel, and a second absorber retaining portion protruding from the second thermal conduction panel toward the first thermal conduction panel, the first and second absorber retaining portions supporting the absorber at a same point.

7. The active heat dissipation apparatus of claim 2, wherein the plurality of absorber retaining portions support the absorber without passing through one surface of the absorber.

8. The active heat dissipation apparatus of claim 2, wherein the absorber comprises:
a first absorption element disposed in close contact with an inner surface of the first thermal conduction panel in the refrigerant flow space; and
a second absorption element disposed in close contact with an inner surface of the second thermal conduction panel in the refrigerant flow space.

9. The active heat dissipation apparatus of claim 7, wherein the plurality of absorber retaining portions comprises:
a first absorber retaining portion protruding from the first thermal conduction panel toward the second thermal conduction panel; and
a second absorber retaining portion protruding from the second thermal conduction panel toward the first thermal conduction panel,
wherein the first absorber retaining portion passes through the first absorption element and supports the second absorption element, and
wherein the second absorber retaining portion passes through the second absorption element and supports the first absorption element.

10. The active heat dissipation apparatus of claim 2, wherein the absorber includes a plurality of joint portion through-holes formed therein such that the plurality of joint portions pass through the absorber and come into surface contact with each other.

11. The active heat dissipation apparatus of claim 2, wherein the plurality of joint portions and the plurality of absorber retaining portions are alternately and repeatedly arranged at intervals to be aligned in a straight line direction on the thermal conduction panel body.

12. The active heat dissipation apparatus of claim 2, wherein, when at least one end of the thermal conduction panel body, in a state where the first thermal conduction panel and the second thermal conduction panel are joined, forms a press-fitting edge that is disposed adjacent to heat-generating elements, which are heat dissipation targets,
the absorber is disposed such that at least a portion of the absorber is disposed linearly along the press-fitting edge.

13. The active heat dissipation apparatus of claim 12, wherein, when a region of each of the first thermal conduction panel and the second thermal conduction panel excluding the press-fitting edge is defined as a heat dissipation plate portion,
a remaining region of the absorber is bent and linearly extended toward a region, located at a relatively lower side with respect to a direction of gravity, of the heat dissipation plate portion.

14. The active heat dissipation apparatus of claim 1, wherein the first thermal conduction panel and the second thermal conduction panel are each provided with at least one chamber partition portion that, after joining the first and second thermal conduction panels, partitions the refrigerant flow space into at least two or more spaces, and during the joining, the chamber partition portions of the first and second thermal conduction panels are joined to each other.

15. The active heat dissipation apparatus of claim 14, wherein in at least the two or more refrigerant flow spaces partitioned by the chamber partition portion, the absorber is disposed in a number corresponding to the number of refrigerant flow spaces.

16. The active heat dissipation apparatus of claim 12, wherein the press-fitting edge is provided with a refrigerant filling port communicating with the refrigerant flow space to allow the refrigerant flow space to be filled with the refrigerant.

17. The active heat dissipation apparatus of claim 16, further comprising a caulking element that is inserted, after the refrigerant flow space is filled with the refrigerant, into the refrigerant filling port and seals the refrigerant flow space by crimping the refrigerant filling port.

18. The active heat dissipation apparatus of claim 17, wherein, after the caulking element is inserted into the refrigerant filling port, the refrigerant filling port including the caulking element is cut to match an outer end of the press-fitting edge.

19. The active heat dissipation apparatus of claim 12, wherein, when an edge opposite to the press-fitting edge is defined as a heat dissipation edge,
a rigidity rib configured to increase rigidity is formed along the heat dissipation edge.

20. The active heat dissipation apparatus of claim 19, wherein the rigidity rib comprises:
a first rigidity rib groove formed to be recessed from the first thermal conduction panel toward an outer side of the refrigerant flow space; and
a second rigid rib groove formed to be recessed from the second thermal conduction panel toward the outer side of the refrigerant flow space.
